Europäisches Patentamt

European Patent Office

Office européen des brevets

(11) Veröffentlichungsnummer: **0 301 291**
**A1**

# EUROPÄISCHE PATENTANMELDUNG

(21) Anmeldenummer: **88110922.7**

(22) Anmeldetag: **08.07.88**

(51) Int. Cl.⁴: **G01R 19/155**

(30) Priorität: **29.07.87 CH 2896/87**

(43) Veröffentlichungstag der Anmeldung:
**01.02.89 Patentblatt 89/05**

(84) Benannte Vertragsstaaten:
**DE FR GB IT**

(71) Anmelder: **Reichle + De-Massari AG**
**Elektroingenieure**
**Binzstrasse 31**
**CH-8620 Wetzikon(CH)**

(72) Erfinder: **Reichle, Hans**
**Guldislooweg 16**
**CH-8620 Wetzikon(CH)**

(74) Vertreter: **Petschner, Goetz**
**Patentanwaltsbüro G. Petschner**
**Seidengasse 18**
**CH-8001 Zürich(CH)**

(54) **Prüfgerät für elektrische Leitungen und Schaltungen.**

(57) Das Prüfgerät umfasst ein Griffgehäuse (1) mit einem abragenden Prüfpol (2) und einem, mit letzterem leitend verbundenen Finger-Kontaktstück (3). Die Ausbildung ist dabei derart, dass das metallische Finger-Kontaktstück (3) ein Clip ist, der über eine Spannungsquelle (11) einen ersten Eingang (11′) einer Eingangsstufe (12) einer elektronischen Schaltung (20) bildet, deren zweiter Eingang (2′) mit dem Prüfpol (2) am Griffgehäuse (1) verbunden ist, welche elektronische Schaltung eine erste Oszillatorstufe (14) und eine zweite Oszillatorstufe (15) umfasst, deren Ausgangssignale unterschiedliche Frequenzen aufweisen zur selektiven Anzeige einer Wechselspannung oder Gleichspannung mittels akustischer und/oder optischer Anzeigemittel (17 resp. 18).

Ein solches Prüfgerät gestattet eine eigene Funktionsprüfung und kann zudem zu weiteren Prüfungen herangezogen werden.

## Prüfgerät für elektrische Leitungen und Schaltungen

Die vorliegende Erfindung betrifft ein Prüfgerät für elektrische Leitungen und Schaltungen, mit einem Griffgehäuse, das Widerstandsmittel umgibt, die für einen Ableitstrom durch den menschlichen Körper bei Spannungsprüfung, einerseits mit einem stiftförmigen, am Griffgehäuse ausmündenden Prüfpol und andrerseits mit einem Finger-Kontaktstück in leitender Verbindung steht.

Solche Prüfgeräte sind als einpolige Phasenprüfer resp. Spannungsprüfer im Gebrauch, wobei als Widerstandsmittel eine Glimmlampe dient. Führt die geprüfte Leitung Strom, glüht die Glimmlampe auf, andernfalls wird davon ausgegangen, dass der betreffende Leiter stromlos ist. Ist der verwendete Phasenprüfer allerdings defekt, kann letztere Annahme tödlich sein, was leider immer wieder vorkommt.

Es ist deshalb Aufgabe der vorliegenden Erfindung, ein Prüfgerät der vorgenannten Art zu schaffen, das eine eigene Funk tionsprüfung gestattet und damit funktionssicher wird und welches zudem zu weiteren Prüfungen herangezogen werden kann.

Dies wird erfindungsgemäss nun dadurch erreicht, dass das metallische Finger-Kontaktstück ein Clip ist, der über eine Spannungsquelle einen ersten Eingang einer Eingangsstufe einer elektronischen Schaltung bildet, deren zweiter Eingang mit dem Prüfpol am Griffgehäuse verbunden ist, welche elektronische Schaltung eine erste Oszillatorstufe und eine zweite Oszillatorstufe umfasst, deren Ausgangssignale unterschiedliche Frequenzen aufweisen zur selektiven Anzeige einer Wechselspannung oder Gleichspannung mittels akustischer und/oder optischer Anzeigemittel.

Ein solches Prüfgerät kann nun zunächst weiterhin als einpoliger Spannungsprüfer Verwendung finden, bei welchem allerdings der Ableitstrom durch den menschlichen Körper vergleichsweise den bekannten Glimmlampenprüfern wesentlich geringer ist, da die elektronische Schaltung strombegrenzend wirkt. Zudem kann nun jederzeit eine absolut verlässliche Funktionsprüfung vorgenommen werden, indem durch eine gleichzeitige Berührung von Clip und Prüfpol am Griffgehäuse die Funktionsfähigkeit akustisch und/oder optisch angezeigt wird. Der Clip gestattet weiter ein Anstecken des Prüfgerätes wie einen Schreiber.

Letzteres gibt die Möglichkeit, bei einer bevorzugten Ausführungsform den Clip als Betätigungsmittel für einen Aus-Ein- Schalter im Schalterkreis der Spannungsquelle zu verwenden, wobei der Clip in seiner aufgespreizten Lage beim Anstecken des Prüfgerätes die Spannungsquelle von der elektronischen Schaltung trennt, was die Lebensdauer einer solchen Spannungsquelle, beispielsweise in Form einer 3Volt-Lithium-Batterie erheblich verlängert. Bei Gebrauch des Prüfgerätes wird der Clip durch eine Gegenfeder in Schliesslage gehalten.

Für eine selektive Anzeige von Wechselstrom und Gleichstrom ist es von Vorteil, wenn das Ausgangssignal der wechselstromseitigen Oszillatorstufe vergleichsweise dem Ausgangssignal der gleichstromseitigen Oszillatorstufe eine geringere Frequenz aufweist.

Damit wird es möglich, das Prüfgerät weiter so auszugestalten, dass neben einer Phasenprüfung gegen Ende und einer Funktionsprüfung weitere Prüfungen möglich werden, wie Prüfung von Wechselströmen (Rufkontrolle beim Telefon), Durchgangsprüfungen aller Art, Gleichstrom-Prüfung (a-Leiter gegen Erde u.a.), Kondensator-Prüfung, Transistorenbestimmung und so weiter.

Hierfür ist eine zweipolige Ausführungsform erforderlich, welche dadurch erreicht werden kann, dass direkt am Clip oder kontaktarmseitig des Aus-Ein-Schalters ein weiterer, mit einem Kabel versehener Prüfpol anschliessbar ist.

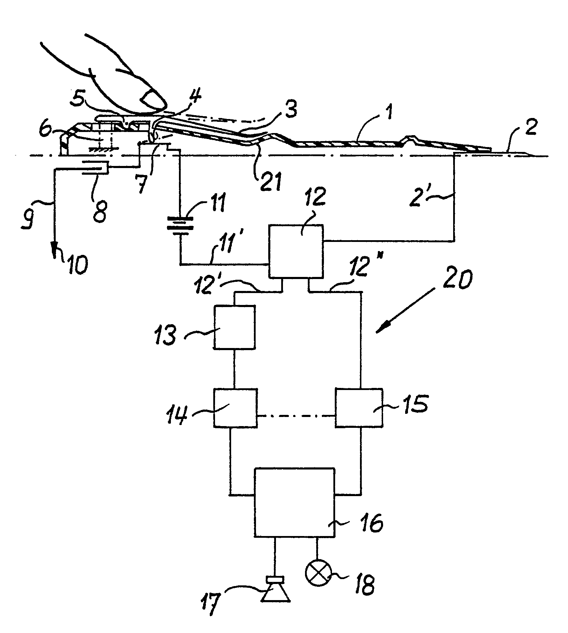

Eine beispielsweise Ausführungsform des Erfindungsgegenstandes ist nachfolgend anhand der Zeichnung, welche ein Prinzip- und Funktionsschema des erfindungsgemässen Prüfgerätes zeigt, näher erläutert.

Das erfindungsgemässe Prüfgerät umfasst ein Griffgehäuse 1 geeigneter, handlicher Form etwa ähnlich dem Griff eines Schraubenziehers in zweiteiliger Schalenausführung oder als Hohlkörper mit abnehmbarer Kappe (nicht gezeigt) um im Innern eine elektronische Schaltung 20 (getrennt gezeigt) unterzubringen. Das Griffgehäuse 1 ist ferner so ausgestaltet, dass an diesem in geeigneter Weise ein Summer 17, eine Leucht-Diode 18 und eine Steckerbuchse 8 angebracht sowie ein Clip 3 kippbar abgestützt werden kann. Ferner ist eine zugängliche Kammer für eine Spannungsquelle in Form etwa einer 3Volt-Lithium-Batterie vorzusehen. Dies alles kann auf verschiedene Weise geschehen und bedarf keiner weiteren Erläuterung.

Erfindungswesentlich ist, dass der Clip 3 ein metallisches Finger-Kontaktstück bildet und über die erwähnte Spannungsquelle 11 einen ersten Eingang 11' einer Eingangsstufe 12 der elektronischen Schaltung 20 bildet, deren zweiter Eingang 2' mit einem üblichen stiftförmigen, metallischen Prüfpol 2 am Griffgehäuse 1 verbunden ist.

Die erwähnte elektronische Schaltung 20 umfasst weiter eine erste Oszillatorstufe 14 sowie eine zweite Oszillatorstufe 15, deren Ausgangssignale unterschiedliche Frequenzen aufweisen zur selektiven Anzeige einer Wechselspannung oder Gleichspannung mittels akustischer und/oder optischer Anzeigemittel 17 resp. 18, welche, wie vorerwähnt ein Summer und eine LED sein können.

Der ersten Oszillatorstufe 14 ist zudem eine Wechselstrom-Detektorstufe 13 vorgeschaltet.

Die Ausbildung des Prüfgerätes kann nun so sein, dass das Ausgangssignal der wechselstromseitigen Oszillatorstufe 14 vergleichsweise dem Ausgangssignal der gleichstromseitigen Oszillatorstufe 15 eine geringere Frequenz aufweist.

Wird dann an die Eingangsstufe 12 eine Wechselspannung angelegt, wie bei der Phasenprüfung oder der Rufkontrolle beim Telefon, ertönt der Summer und leuchtet die Lampe entsprechend der geringen Frequenz des Ausgangssignals der wechselstromseitigen Oszillatorstufe 14 resp. einer nachgeschalteten Verstärkerstufe 16 intermittierend.

Wird hingegen an die Eingangsstufe 12 eine Gleichspannung angelegt, etwa bei der Kontrolle von Telefonleitungen, resp. der Stromkreis über der Spannungsquelle direkt (Funktionsprüfung) oder über Leitermittel (Durchgangskontrolle) geschlossen, ertönt der Summer und leuchtet die Lampe entsprechend der höheren Frequenz des Ausgangssignals der gleichstromseitigen Oszillatorstufe 15 resp. der nachgeschalteten Verstärkerstufe 16 dauernd resp. mit so hohen Schwingungen, dass eine deutliche Unterscheidung von den Signalen bezüglich Wechselstrom möglich ist.

Um das Gerät ausschalten zu können, ist zwischen Spannungsquelle 11 und Clip 3 ein Aus-Ein-Kontakt 7 vorgesehen, der ein Kippschalter oder dgl. sein kann. Vorteilhaft ist aber, den Clip 3 als Betätigungsmittel für den Schalter 7 zu verwenden. Hierfür ist der Clip über einen Steg 4 kontakt- und funktionssicher mit dem beweglichen Schalterkontakt verbunden und um einen Lagerstift 5 gegen die Wirkung einer Gegenfeder 6 aus einer gezeigten Schliesslage in eine Kontakt öffnende Lage kippbar, etwa beim Anstecken des Prüfgerätes.

Um dabei einen, für ein sicheres Kontakt öffnen ausreichenden Kippweg zu erhalten, ist es von Vorteil, am Griffgehäuse 1 im Bereich des freien Endes des Clip 3 eine Einschnürung 21 vorzusehen, in die der freie Cliparm eintaucht. Beim Anstecken wird dann der Clip durch den zwischenliegenden Kleiderstoff oder dgl. weit nach aussen gedrückt und der Kontakt 7 geöffnet.

Um das Prüfgerät zweipolig auszugestalten, kann fest mit dem Clip 3 oder dem beweglichen Kontaktarm 7 über ein Kabel 9 geeigneter Länge ein weiterer Prüfpol 10 verbunden sein.

Vorzugsweise ist aber der Prüfpol 10 über sein Kabel 9 kontaktarmseitig mittels Steckbuchse 8 verbindbar.

Auf diese Weise ist ein handliches Prüfgerät von grosser Vielfältigkeit in der Anwendung geschaffen, das vor jedem Gebrauch eine absolut sichere Eigenfunktionsprüfung gestattet, was Unfälle jener Art, die durch Glimmlampenprüfer hervorgerufen wurden, vollständig ausschliesst.

## Ansprüche

1. Prüfgerät für elektrische Leitungen und Schaltungen, mit einem Griffgehäuse, das Widerstandsmittel umgibt, die, für einen Ableitstrom durch den menschlichen Körper bei Spannungsprüfung, einerseits mit einem stiftförmigen, am Griffgehäuse ausmündenden Prüfpol und andrerseits mit einem Finger-Kontaktstück in leitender Verbindung steht, dadurch gekennzeichnet, dass das metallische Finger-Kontaktstück (3) ein Clip ist, der über eine Spannungsquelle (11) einen ersten Eingang (11') einer Eingangsstufe (12) einer elektronischen Schaltung (20) bildet, deren zweiter Eingang (2') mit dem Prüfpol (2) am Griffgehäuse (1) verbunden ist, welche elektronische Schaltung eine erste Oszillatorstufe (14) und eine zweite Oszillatorstufe (15) umfasst, deren Ausgangssignale unterschiedliche Frequenzen aufweisen zur selektiven Anzeige einer Wechselspannung oder Gleichspannung mittels akustischer und/oder optischer Anzeigemittel (17 resp. 18).

2. Prüfgerät nach Anspruch 1, dadurch gekennzeichnet, dass der Clip (3) als Betätigungsmittel für einen Aus-Ein-Schalter (7) im Schaltkreis der Spannungsquelle (11) dient, wobei eine Gegenfeder (6) den Clip (3) in Schliesslage hält.

3. Prüfgerät nach Anspruch 1, dadurch gekennzeichnet, dass das Ausgangssignal der wechselstromseitigen Oszillatorstufe (14) vergleichsweise dem Ausgangssignal der gleichstromseitigen Oszillatorstufe (15) eine geringere Frequenz aufweist.

4. Prüfgerät nach Anspruch 1 oder 2, dadurch gekennzeichnet, dass direkt am Clip (3) oder kontaktarmseitig des Aus-Ein-Schalters (7) ein weiterer, mit einem Kabel (9) versehener Prüfpol (10) anschliessbar ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | US-A-3 805 155 (CANON) <br> * Zusammenfassung; Anspruch 1; Figur 1 * <br> --- | 1,3,4 | G 01 R 19/155 |
| Y <br><br> A | US-A-4 205 264 (GOLD) <br> * Spalte 6, Zeilen 9-58; Figuren 1-3 * <br><br> --- | 1,3 <br><br> 2,4 | |
| Y | US-A-4 152 639 (CHAFFEE) <br> * Spalte 7, Zeilen 25-42; Anspruch 4; Figur 12 * <br> --- | 4 | |
| A | DE-U-7 401 610 (L. MERS) <br> * Ansprüche 1,2; Seite 6, Zeilen 15-23 * <br> --- | 1 | |
| A | ETZ, Band 102, Nr. 14, 1981, Seite 747, Berlin, DE; C.A. WEIDMÜLLER: "Universaltester U1T GmbH" <br> ----- | 1 | |

| RECHERCHIERTE SACHGEBIETE (Int. Cl.4) |
|---|
| G 01 R 19/00 <br> G 01 R 1/00 <br> G 01 R 35/00 |

Der vorliegende Recherchenbericht wurde für alle Patentansprüche erstellt

| Recherchenort | Abschlußdatum der Recherche | Prüfer |
|---|---|---|
| DEN HAAG | 15-09-1988 | WIEMANN L. |